(19) Europäisches Patentamt
European Patent Office
Office européen des brevets

(11) **EP 4 010 714 B1**

(12) **EUROPÄISCHE PATENTSCHRIFT**

(45) Veröffentlichungstag und Bekanntmachung des Hinweises auf die Patenterteilung:
**03.05.2023   Patentblatt 2023/18**

(21) Anmeldenummer: **20761756.4**

(22) Anmeldetag: **07.08.2020**

(51) Internationale Patentklassifikation (IPC):
*G01R 15/20* (2006.01)     *G01R 33/00* (2006.01)
*G01R 33/022* (2006.01)     *G01R 33/07* (2006.01)
*G01R 33/09* (2006.01)

(52) Gemeinsame Patentklassifikation (CPC):
**G01R 15/207; G01R 33/0017; G01R 33/0076;**
**G01R 33/022;** G01R 33/072; G01R 33/091

(86) Internationale Anmeldenummer:
**PCT/EP2020/072293**

(87) Internationale Veröffentlichungsnummer:
**WO 2021/023874 (11.02.2021 Gazette 2021/06)**

(54) **MAGNETFELDBASIERTER STROMSENSOR ZUR FREQUENZKOMPENSIERTEN MESSUNG VON WECHSELSTRÖMEN**

MAGNETIC FIELD-BASED CURRENT SENSOR FOR FREQUENCY-COMPENSATED MEASUREMENT OF ALTERNATING CURRENTS

CAPTEUR DE COURANT À BASE DE CHAMP MAGNÉTIQUE POUR LA MESURE COMPENSÉE EN FRÉQUENCE DE COURANTS ALTERNATIFS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **08.08.2019   DE 102019121458**
**11.09.2019   DE 102019124391**

(43) Veröffentlichungstag der Anmeldung:
**15.06.2022   Patentblatt 2022/24**

(73) Patentinhaber: **Sensitec GmbH**
**35578 Wetzlar (DE)**

(72) Erfinder:
• **GLENSKE, Claudia**
**35638 Leun (DE)**
• **BRUSIUS, Matthias**
**35080 Hartenrod (DE)**

(74) Vertreter: **Spachmann, Holger**
**Stumpf Patentanwälte PartGmbB**
**Alte Weinsteige 73**
**70597 Stuttgart (DE)**

(56) Entgegenhaltungen:
EP-A2- 2 775 311     WO-A1-2019/072421
DE-A1-102017 114 377     US-A1- 2017 067 941

**Beschreibung**

Die vorliegende Erfindung betrifft einen Wechselstromsensor mit frequenzkompensierter Messcharakteristik zur exakten magnetfeldbasierten Messung von Stromstärken durch einen Stromleiter über einen großen Frequenzbereich. Daneben betrifft die Erfindung eine Verwendung eines derartigen Wechselstromsensors.

STAND DER TECHNIK

Magnetfeldbasierte Stromsensoren dienen zur galvanisch getrennten, berührungsfreien Messung von Strömen

Im Rahmen der Erfindung werden magnetfeldbasierte Stromsensoren betrachtet, die zur Messung der Stärke eines Stromes mit zumindest wechselstrombehafteten Anteilen durch einen oder mehrere Leiter auf Basis des Leiters umgebenden Magnetfeldes dienen. Der Strom kann ein reiner, in der Regel sinusförmiger, Wechselstrom (AC-Strom), ein mit einer Gleichstrom (DC-Strom) behafteter Wechselstrom, ein oberwellenbehafteter Strom mit einer oder mehreren Frequenzkomponenten oder auch ein Gleichstrom mit hoher Schaltfrequenz - jedenfalls ein Strom, der ein wechselndes Magnetfeld hervorruft, dass in der Lage ist, Wirbelströme in metallischen Leitern zu induzieren.

Gattungsgemäße Stromsensoren werden beispielsweisen in den Bereichen Powertrain und Charging für E-Mobility und in der automotiven Anwendungen bei elektrisch angetriebene Personen- und Nutzfahrzeugen, industrielle Großantrieben und in der regenerativen Energietechnik wie Photovoltaik oder Windkraft eingesetzt. Derzeit werden in diesen Bereichen konventionelle Stromsensoren in closed-/open-Loop Hall- oder Fluxgate-Technologie sowie Trennwandler mit entkoppelten Messshunts eingesetzt. Derartige Stromsensoren sind preisgünstig und weisen eine niedrige Frequenzbandbreite auf. Allerdings verbrauchen diese auch einen relativ großen Bauraum und haben eine erhöhte EMC-Empfindlichkeit (Elektromagnetic Compatibility) oder benötigen eine zusätzliche Kühlung.

Berührungsfreie Stromsensoren zur Messung der Stärke eines Stromes durch einen oder mehrere Stromleiter auf Basis des, den Stromleiters umgebenden, Magnetfeldes H entlang einer geschlossenen Kurve S, sind im Stand der Technik hinlänglich bekannt. Sie beruhen auf einem Rückschluss auf den Gesamtstrom I, der durch die Fläche A fließt, die durch die Kurve S berandet wird, nach dem Ampèreschen Gesetz:

$$I = \iint\limits_{A} \vec{J} \cdot d\vec{A} = \oint\limits_{S} \vec{H} \cdot d\vec{s}$$

Hierdurch ist eine berührungslose Stromerfassung ohne Eingriff in den Betrieb einer elektrischen Schaltung, insbesondere ohne Unterbrechung oder Zwischenschaltung eines elektrischen Stromkreises möglich.

Aus dem Stand der Technik sind Anordnungen bekannt, die mittels magnetfeldempfindlichen Gradientensensoren eine magnetische Feldstärkedifferenz in einer Messebene zwischen Leiterströmen benachbarter Stromleiter messen. Als magnetfeldempfindliche Sensorelemente werden in der Regel magnetoresistive Sensorelemente eingesetzt, die zum Beispiel nach dem planaren Hall-Effekt, dem AMR-Effekt, dem GMR-Effekt oder dem TMR-Effekt arbeiten, oder die als Feldplatte (MDR - Magnetic Dependent Resistor) ausgebildet sind. Dazu gehören aber auch Sensoren, die eine magnetfeldabhängige Spannung bereitstellen, wie z.B. Hall-Sensoren, oder anderweitig ein Sensorsignal in Abhängigkeit der Stärke des Magnetfeldes bereitstellen. Beispielhaft und nicht abschließend wird weiter auf SQUID-basierte Sensoren (Superconducting Quantum Interference Device) oder auf ein Fluxgate-Magnetometer verwiesen.

Im Bereich der magnetoresistiven Sensorelemente beruht der AMR-Effekt auf einer magnetfeldbasierten Widerstandsänderung in einer ferromagnetischen Schicht, die eine innere Polarisierung aufweist, wobei ein äußeres Magnetfeld eine Winkeländerung des resultierenden Magnetvektors der ferromagnetischen Schicht zur Stromrichtung bewirkt. TMR- und GMR-Sensoren basieren auf dem TMR- bzw. GMR-Effekt und bestehen aus einer Mehrzahl von wenigen Nanometern dünnen Schichten, wobei zumindest eine Referenzschicht eine fest ausgerichtete Magnetisierung aufweist und die Magnetisierung einer freien Schicht einem äußeren Magnetfeld folgt. Der Winkel der Magnetisierungen zwischen Referenzschicht und freier Schicht beeinflusst den Widerstandswert, der sich mit der Winkeländerung des äußeren magnetischen Feldes ändert.

Werden zwei Sensorelemente in einem Abstand nebeneinander platziert, so kann durch eine differentielle Auswertung der Sensorsignale der Sensor robust gegenüber externen Störfeldern gemacht werden. Der Differenzenquotient wird als Gradient des Magnetfeldes verstanden. Diese Gradientensensoren eignen sich besonders gut für die Anwendung in Stromsensoren. Somit können derartige magnetfeldempfindliche Sensorelemente als Gradientensensoren, beruhend auf zwei Magnetfeldsensoren, ausgebildet sein, wobei die jeweiligen Magnetfeldsensoren das von jedem Stromteil verursachte Magnetfeld erfassen und die Magnetfeldsensoren hieraus intern oder extern den Gradientenwert bestimmen.

In einem magnetfeldempfindlichen Stromsensor ist das Sensorelement im Bereich des strommessaktiven Leiterabschnitts so angeordnet, dass das Magnetfeld des strommessaktiven Leiterabschnitts eine hohe Sensorwertveränderung, insbesondere eine hohe Widerstandsveränderung hervorruft, und das Magnetfeld des strommessparasitären Leiterabschnitts aufgrund der räumlichen Ausrichtung des Sensorelements gegenüber dem strommessparasitären Leiterabschnitt und/oder durch Feldkompensationseffekte weiterer stromführender Elemente geringe, im Wesentlichen keine Sensorwertveränderungen hervorruft.

Bisherige Lösungen zur Strommessung in Gradiometeranordnung basieren in der Regel auf U-förmigen Stromleitern zur Erzeugung eines primärstromabhängigen Feldgradienten, wie diese beispielsweise in der DE 43 00 605 A1 beschrieben ist. Hierzu wird ein in beiden Schenkeln des U-förmigen Stromleiters ein fließender Strom betrachtet, wobei der in einen Schenkel hinein- und im benachbarten Schenkel herausfließende Strom ein superpositioniertes Gesamtmagnetfeld zwischen den Schenkeln ausbildet, dessen Feldgradient in einer Messebene erfasst wird. Naturgemäß fliest in beiden Schenkeln die identische Strommenge, allerdings in gegenläufigen Richtungen. Mit zunehmender Miniaturisierung treten in einem derartigen Stromsensors Störfeldanteile auf, die z.B. durch Ströme in dem Verbindungssteg zwischen den Schenkeln des U-Leiters entstehen und eine Größe annehmen, die zu einer Veränderung der Magnetisierung der magnetfeldempfindlichen Schichten des xMR-Sensors führt.

Zu dieser vorbekannten U-förmigen Geometrie ist in der WO 2014/001473 A1 eine Weiterentwicklung dargestellt, wobei der U-förmige Stromleiter zumindest einen strommessaktiven Leiterabschnitt und zumindest einen strommessparasitären Leiterabschnitt umfasst. Das Sensorelement weist zumindest eine Empfindlichkeitsrichtung auf, in der Magnetfeldkomponenten eine hohe Sensorwertveränderung bewirken. Hierzu ist das Sensorelement derart im Bereich des strommessaktiven Leiterabschnitts ausgerichtet, insbesondere gegenüber dem strommessparasitären Leiterabschnitt verdreht, gekippt und/oder höhenversetzt, so dass das Magnetfeld eines strommessaktiven Leiterabschnitts des U-förmigen Leiterelements im Wesentlichen in Empfindlichkeitsrichtung und das Magnetfeld eines strommessparasitären Leiterabschnitts des U-förmigen Leiterelements im Wesentlichen nicht in Empfindlichkeitsrichtung, insbesondere rechtwinklig zur Empfindlichkeitsrichtung, ausgerichtet ist. Zur Stützung der Empfindlichkeit des Sensorelements können die parallelen Schenkel von Permanentmagneten flankiert sein, die ein Hilfsmagnetfeld zur Stützung einer inneren Magnetisierung des Sensorelements bereitstellen.

Die Induktivität, die durch den U-förmigen Stromschenkel gebildet wird, führt zu Spannungsspitzen, die von einer eingeschalteten Leistungshalbleiterelektronik, die z.B. für einen Umrichterbetrieb ausgelegt ist, kompensiert werden muss. Diese muss daher für höhere Spannungsspitzen ausgelegt sein.

In jüngster Zeit ist daher eine Weiterentwicklung eines Stromsensors in der WO 2019/072421 A1 beschrieben, der anstelle eines U-förmigen Stromschenkels zwei parallele, und gegenüber einer Messebene eines Gradientensensorelementes höhenversetzte Leiterabschnitte aufweist, durch die jeweils ein Teil des zu messenden Stromes in gleicher Richtung fließt. Durch die Stromaufteilung kann die Strombelastung der Leiterabschnitte herabgesetzt und parasitäre Störfelder eines Querschenkels oder der Anschlussleitung vermieden werden.

Im Bereich der Wechselstrommessung tritt der Skin-Effekt aufgrund von Selbstinduktion des vom Strom erzeugten Wechselmagnetfelds im Stromleiter auf. Durch einen hochfrequenten Wechselstrom im Stromleiter stellt sich eine Stromdichte durch einen Stromverdrängungseffekt in den Innenbereichen des Leiters niedriger als in den Außenbereichen ein. Das heißt, dass beim Wechselstrom in Abhängigkeit der Frequenz Wirbelströme und elektromagnetische Felder erzeugt werden, die die Ladungsträger an die Oberfläche des Leiters verdrängen. Hierdurch verändert sich allerdings bei zunehmender Frequenz das den Stromleiter umgebende Magnetfeld, so dass das Sensorelement bei gleicher Strommenge ein anderes Magnetfeld als im Falle von Gleichstrom sieht. Zur Erhöhung der Messgenauigkeit eines Stromsensors ist beispielsweise aus der DE 101 10 254 A1 bekannt, den Querschnitt des Stromleiters derart auszuformen, so dass keine Wirbelströme im Stromleiter selbst auftreten können.

Weiterhin offenbart das Dokument DE 10 2017 114377 A1 einen Stromsensor zur magnetfeldbasierten Strombestimmung eines Wechselstromes durch einen Stromleiter auf Basis eines magnetfeldempfindlichen Sensorelements, wobei das Sensorelement räumlich benachbart zum Stromleiter zur Erfassung eines durch den Wechselstrom im Stromleiter hervorgerufenen Magnetfeldes angeordnet ist. Dabei sind zwei als leitfähige Kompensationselemente ausgebildete Metallkörper in Form von leitenden Platten galvanisch getrennt vom Fluss des Wechselstroms durch den Stromleiter und räumlich benachbart zum Sensorelement und zum Stromleiter angeordnet. Der offenbarte Stromsensor weist damit eine reduzierte Frequenzabhängigkeit auf.

Daneben wirkt ein Proximity-Effekt zwischen zwei eng benachbarten Leitern. Der Proximity-Effekt ist ein Phänomen der Stromverdrängung, wobei sich dieses frequenzabhängige Phänomen auf Wirbelströme zwischen eng beieinander liegenden Leitern beschränkt, in denen Wechselströme in gleiche oder entgegengesetzte Richtungen fließen, wie dies bei den vorbekannten Strommesssensoren mit höhenversetzten Leiterabschnitten bzw. U-förmigen Leiterabschnitten der Fall ist. Je nach Stromstärke kann der Proximity-Effekt über einen Abstand der Leiter von wenigen Millimeter bis zu einigen Zentimeter wirken. Nach dem Proximity-Effekt, der bei höheren Frequenzen besonders ausgeprägt ist, tendieren entgegengesetzt gerichtete hochfrequente Ströme wie in einem U-förmigen Stromleiter dazu, in möglichst enger Nähe zueinander zu fließen, und gleichgerichtete hochfrequente Ströme, wie in höhenversetzten parallelen Stromleiter dazu, sich gegenseitig zu verdrängen. Der Stromfluss konzentriert sich auf den Bereich, bei denen die beiden Leiter dicht nebeneinander liegen bzw. die weit voneinander entfernt sind.

Ursache von Skin- und Proximity-Effekt sind abstoßende Lorentz-Kräfte der entgegengesetzten Ströme bzw. gleichgerichteten Teilströme in beiden Leiterabschnitten, verstärkt durch Wirbelströme im Inneren der Leiterabschnitte. Im Gegensatz zum U-Stromleiter wo der Proximity Effekt Stromkonzentration nah am Sensor hervorruft und damit einhergehende Amplitudenanstiege im Frequenzgang der Sensoranordnung mit RC-Gliedern kompensiert werden können ist bei höhenversetzten Leiterabschnitten ein Anheben der Amplitude bei höheren Frequenzanteilen ohne Verlust der DC-Messfähigkeit oder erheblichen Aufwand am Messsignal kaum möglich. Unterbindung dieser HF-Stromdichteneffekte durch Verwendung von z.B. in sich isolierten HF-Litzen scheitert an Wirtschaftlichkeit und der Möglichkeit, hinreichend große Felder am Sensorort zu erzeugen angesichts der geringen Stromtragfähigkeit pro Leitungsdurchmesser der HF-Litze verglichen mit Vollmaterial.

Infolge einer Überlagerung der beiden vorgenannten Effekte wird bei der U-förmigen Stromleitern eine hohe Stromdichte in den Innenbereichen der Schenkel, insbesondere in den Kanten, hervorgerufen. Bei höhenversetzten parallel durchflossenen Stromleitern tritt aufgrund der vorgenannten Verzerrungseffekte eine hohe Stromdichte in den Außenbereichen, insbesondere in den Kanten auf. Somit werden hochfrequente Ströme deutlich dichter bzw. weniger dicht geführt und es erhöht sich der Feldgradient bzw. verringert sich der Feldgradient im Bereich des Sensors gegenüber einer reinen Gleichstrommessung. Insofern sind die vorbekannten Stromsensoren in ihrer Messqualität von der Stromfrequenz abhängig, wobei bei identischen Stromstärken und unterschiedlichen Frequenzen unterschiedliche Signalwerte des Stromsensors erzeugt werden.

Somit ergibt sich ausgehend vom vorgenannten Stand der Technik das Problem, dass sich Messfehler in Abhängigkeit von der Stromfrequenz bzw. des transienten Stromverhaltens einstellen.

Bei einer reinen DC oder reinen AC-Messung mit begrenztem Frequenzbereich, kann die Geometrie auf genau diesen Fall ausgelegt werden, werden aber Grenzen überschritten steigt der Fehler deutlich. Für einen Stromsensor mit U-Stromleiter kann eine relativ komplexe Geometrie für ausgewählte Anwendungsfälle und in engen, vorbekannten Frequenzbereichen eine Kompensation von Skin- und Proximity-Effekt erreicht werden.

Daneben kann durch eine aufwendige Signalverarbeitung durch Ermittlung der Frequenzkomponenten eine nachträgliche Korrektur in gewissen Frequenzbereichen vorgesehen werden.

Ausgehend vom dem oben genannten Stand der Technik ist es die Aufgabe der Erfindung, die Nachteile der bekannten Anordnungen zu verringern. Insbesondere soll mit einem einfachen kostengünstigen Aufbau hohe Stromstärken von mehreren hundert Ampere über einen großen Frequenzbereich messbar sei. Wünschenswert sind geringe räumliche Abmessungen und gute Messgenauigkeiten bei Arbeitsfrequenzen von DC bis zu 50 bis150kHz.

Die oben genannten Nachteile werden durch einen Stromsensor nach Anspruch 1 gelöst. Vorteilhafte Weiterbildungen der Erfindung sind Gegenstand der Unteransprüche.

OFFENBARUNG DER ERFINDUNG

Die Lösung der Aufgabe erfolgt durch eine Stromsensor zur magnetfeldbasierten Strom-bestimmung eines Wechselstromes I durch einen Stromleiter auf Basis eines magnetfeldempfindlichen Sensorelements, wobei das Sensorelement räumlich benachbart zum Stromleiter zur Erfassung eines durch den Wechselstromes I im Stromleiter hervorgerufenen Magnetfeldes angeordnet ist,

Für den erfindungsgemäße Stromsensor wird vorgeschlagen, dass zumindest ein leitfähiges Kompensationselement getrennt vom Fluss des Wechselstroms I durch den Stromleiter und räumlich benachbart zum Sensorelement und zum Stromleiter zur Kompensation von frequenzabhängigen Verzerrungen des Magnetfeldes mittels eines durch Induktion erzeugbaren Kompensationsmagnetfelds angeordnet ist.

Bei einem Wechselstrom (AC-Strom) werden in den als Metallklötze ausgebildeten Kompensationselementen durch Induktion des Wechselmagnetfeldes Wirbelströme erzeugt, die bei passender Anordnung der Kompensationselemente die unerwünschte Stromverteilung durch Skin- und Proximity-Effekt im Stromleiter kompensieren bzw. deutlich unterdrücken können. Im optimalen Fall ist das magnetische Feld, das entsteht komplett unabhängig von der Stromfrequenz.

Die Erfindung erweitert den einsetzbaren Frequenzbereich erheblich, so dass es keine Einschränkung mehr im Nutzungsbereich gibt. Die Geometrie des Stromleiters kann wie bisher relativ einfach ausgeführt sein. Die Komplexität einer Filterschaltung der nachgeschalteten Elektronik kann simplifiziert werden oder ggf. vollständig entfallen. Schließlich kann eine deutliche Kostenreduzierung in der Herstellung und Integration des Stromsensors in ein elektrisches System erreicht werden.

Der erfindungsgemäße Stromsensor beruht auf dem Prinzip, den Magnetfeldgradienten zur Strommessung im zu messenden Frequenzbereich konstant zu halten. Durch die Kompensationselemente werden bei hohen Frequenzen entgegenwirkende Wirbelströme induziert, diese Wirkung kann als "Wirbelstromfallen" bezeichnet werden. Die Kompensation kann unabhängig von der Technologie des eingesetzten Stromsensors eingesetzt werden, und somit für xMR, Hall oder allen anderen Sensorelement-Technologien zur Messung von Magnetfeldgradienten verwendet werden, da einzig die Frequenzabhängigkeit des Magnetfeldes am Sensorort manipuliert wird.

Ein wesentlicher Vorteil der Anordnung mit Kompensationselementen besteht darin, dass störende Einflüsse frequenzabhängiger Stromdichteneffekte direkt am Magnetfeldgradienten als Eingangsgröße des Messsystems mit einfachen Mitteln kompensiert werden. Dies erlaubt im Gegensatz zu vorbekannten Stromsensoren einer Kompensation bereits am Messausgang des Sensorelements, so dass eine nachträgliche Behandlung des Messsignals beispielsweise mit RC-Gliedern, die in der Regel frequenzbereichsreduzierend ist, verzichtet oder vereinfacht werden kann. Dieser Bandbreitenvorteil erschließt Anwendungen des Stromsensors in der modernen Leistungselektronik bei höherer Energieeffizienz und Leistungsdichten durch gesteigerte Arbeitsfrequenzen.

Als Wechselstrom I wird im Rahmen der Erfindung ein Strom mit wechselbehafteten Anteilen angesehen, der in der Lage ist, derartige Wechselmagnetfelder um den Stromleiter zu erzeugen, so dass diese wiederum Wirbelströme in dem Kompensationselement induzieren können. Diese Wirbelströme erzeugen daraufhin ein Kompensationsmagnetfeld, dass das frequenzbedingt verzerrte Ursprungsmagnetfeld aufgrund von Skin- und Proximity-Effekt kompensieren kann. Dazu gehören außer reinen Wechselströmen (AC-Strömen) auch mit einem Gleichspannungsanteil behaftete Wechselströme und oberwellenbehaftete Gleichströme (DC-Ströme) sowie allgemein oberwellenbehaftete Ströme oder auch Gleichströme, die eine Reihenfolge von schnellen Schaltvorgängen aufweisen, die beispielsweise in der PWM-Modellierung oder bei Übertragung digitaler Informationen auftreten können. Auch kann beispielsweise beim Einsatz einer Doppelwechselrichterstruktur z.B. zur Speisung eines Elektromotors, ein Wechselrichter mit Nennfrequenz und ein zweiter Wechselrichter mit einer weitaus höheren Frequenz zur Glättung von Oberwellen eingesetzt werden. Hierbei zu messende Strangströme umfassen eine Vielzahl von Frequenzkomponenten, die gegenüber den aus dem Stand der Technik bekannten Stromsensoren, die deutliche Ungenauigkeiten aufweisen würden, exakt gemessen werden können.

In einer vorteilhaften Ausführungsform wird vorgeschlagen, dass das Kompensationselement eine Leitfähigkeit aufweist, die größer oder gleich der Leitfähigkeit des Stromleiters sein kann. Bevorzugt kann das Kompensationselement aus Kupfer, Aluminium oder Silber bestehen. Hierdurch können auch bei schwachen Wechselfeldern bereits Ströme in das Kompensationselement induziert und ein Kompensationsmagnetfeld hervorgerufen werden. So kann beispielsweise das Kompensationselement aus Kupfer bestehen, während der Stromleiter aus Aluminium hergestellt ist.

In einer vorteilhaften Ausführungsform wird vorgeschlagen dass der Stromleiter zwei Leiterabschnitte umfassen kann, wobei das Sensorelement zwischen den beiden Leiterabschnitten angeordnet sein kann, und bevorzugt als Gradientensensor ausgebildet ist. Dabei kann zumindest ein, und bevorzugt zwei Kompensationselemente im Wesentlichen entlang eines sensoraktiven Teilabschnitts dem Verlauf der beiden Leiterabschnitte folgen. Damit wird eine einfache Struktur des Stromleiters mit zwei getrennten, vom Strom durchflossenen, Leiterabschnitten vorgeschlagen. Die Leiterabschnitte können parallel zueinander ausgerichtet sein und können in gleicher oder entgegengesetzter Richtung vom Strom I oder jeweils von einem Teil des Stroms I durchflossen werden. Die Kompensationselemente können im Wesentlichen dem Verlauf der Leiterabschnitte folgen und in räumlicher Nähe zu den Leiterabschnitten und zum Sensorelement angeordnet sein, um das Wechselmagnetfeld hinsichtlich eines DC-Verhaltens zu beeinflussen, wobei eine fertigungstechnisch einfach herstellbare und kostengünstige Kompensation der frequenzbedingten Feldverzerrungen ermöglicht wird.

In einer vorteilhaften Ausführungsform wird vorgeschlagen dass sich der durch die Leiterabschnitte fließende Wechselstrom I des Stromleiters bezogen auf eine Querschnittsebene durch die Leiterabschnitte aufteilt und in gleicher Richtung fließt. Hierzu kann insbesondere ein Aufspaltung des Stromleiters in zwei parallele Leiterabschnitte vorgesehen sein, wobei der Gesamtstrom in zwei Teilströmen durch die beiden, in der Regel parallel geführten, Leiterabschnitte geleitet wird. Das Sensorelement ist zwischen den beiden Leiterabschnitten angeordnet und die Kompensationselemente korrigieren die jeweils von beiden Leiterabschnitten gleichsinnig orientierten Wechselmagnetfelder hinsichtlich eines DC-Verhaltens. Hierzu sind die Kompensationselemente als leitfähige Vollkörper, metallische Klötze, ausgeformt, die vom Sensorelement aus gesehen zwischen oder abgewinkelt zu den Leiterabschnitten und dem Sensorelement in einem vergleichbaren oder geringeren Radius wie die Leiterabschnitte angeordnet sind. Alternativ können die Leiterabschnitte auch so geführt sein, dass der Gesamtstrom I gleichgerichtet bezüglich des Sensorelements durch einen Leiterabschnitt und durch den zweiten Leiterabschnitt geführt ist, um bei niedrigen Strömen eine Magnetfelderhöhung und somit eine Sensitivitätserhöhung zu erreichen.

Aufbauend auf die vorgenannte Ausführungsform können weiterhin vorteilhaft die Leiterabschnitte des Stromleiters bezüglich einer Messebene des magnetfeldempfindlichen Gradientensensors höhenversetzt sein. Insbesondere kann ein Leiterabschnitt unterhalb und ein Leiterabschnitt oberhalb der Messebene geführt sein, wobei bezogen auf das Sensorelement zumindest zwei Kompensationselemente und das Sensorelement auf einer Ebene, die nicht die Messebene sein muss, angeordnet sein können, die abgewinkelt, insbesondere die rechtwinklig, zu einer durch die Leiterabschnitte und das Sensorelement verlaufenden Ebene verläuft. Weiterhin kann bevorzugt ein radialer Abstand der Kompensationselemente zum Sensorelement gleich oder kleiner als ein radialer Abstand der Leiterabschnitte zum Sensorelement sein. Die exakten geometrischen Abstände und Gestaltung der Kompensationselemente kann nach Vorgabe des zu messenden Nennstroms und des angestrebten Frequenzbereichs beispielsweise aufgrund von elektromagnetischen Simulationsverfahren und Erfahrungswerten spezifiziert werden.

Alternativ zur vorgenannten Ausführungsform kann der durch die Leiterabschnitte des Stromleiters fließende Wechselstrom I bezogen auf eine Querschnittsebene durch die Leiterabschnitte in entgegengesetzte Richtung fließen. Dabei kann insbesondere ein U-förmiger Verlauf des Stromleiters gegeben sein, wobei der Gesamtstrom in einem Leiterabschnitt geführt und im parallelen zweiten Leiterabschnitt rückgeführt wird. Das Sensorelement ist höhenversetzt zwischen den beiden Leiterabschnitten angeordnet, so dass die Magnetfelder eine Tangentialkomponente in Richtung der Leiterabschnitte aufweist, und die Kompensationselemente korrigieren die jeweils von beiden Leiterabschnitten gegensinnig orientierten Wechselmagnetfelder hinsichtlich eines DC-Verhaltens. Hierzu sind die Kompensationselemente als leitfähige Vollkörper, metallische Klötze, ausgeformt, die vom Sensorelement aus gesehen die Leiterabschnitte flankieren. Alternativ können die Leiterabschnitte auch so geführt sein, dass jeweils ein Teil des Gesamtstroms I durch einen Leiterabschnitt und ein Teil des Gesamtstroms I durch einen zweiten Teil des Leiterabschnitts allerdings bezüglich der Lage des Sensorelements gegensinnig geführt ist, um bei hohen Strömen eine Magnetfeldreduktion und somit eine Messbereichserweiterung zu ermöglichen.

Aufbauend auf der vorgenannten Ausführungsform können die Leiterabschnitte des Stromleiters und zumindest zwei Kompensationselemente in einer höhenversetzten und parallel zur Messebene des Sensorelements angeordneten Ebene liegen, wobei der radiale Abstand der Kompensationselemente größer als der radiale Abstand der Leiterabschnitte zum Sensorelement ist. Insbesondere können die Kompensationselemente in einem sensoraktiven Teilabschnitt symmetrisch die Leiterabschnitte einfassen. Insoweit wird entlang einer Messebene des Sensorelements symmetrisch zu beiden Seiten die Leiterabschnitte und radial weiter außenliegend die Kompensationselemente angeordnet. Wie bereits ausgeführt tritt eine Stromkonzentration und Feldüberhöhung bei zunehmender Frequenz im Bereich des Sensorelements auf. Um diesen entgegenzuwirken, erzeugen die außen liegenden Kompensationselemente aufgrund der Induktivitätserhöhung ein Kompensationsfeld, das der Feldüberhöhung zwischen den Leiterabschnitten entgegenwirkt und somit eine vergleichbare Feldverteilung wie im DC-Fall ermöglicht. Dadurch können frequenzabhängige Signalwertverzerrungen in einem weiten Frequenzbereich effektiv kompensiert werden.

In einer vorteilhaften Weiterentwicklung der vorgenannten Ausführungsform kann der Stromleiter im Wesentlichen U-förmig mit zwei parallelen Schenkeln und einem Querschenkel ausgebildet sein, wobei die beiden parallelen Schenkel des Stromleiters die Leiterabschnitte bilden, und wobei bevorzugt räumlich benachbart zum Querschenkel ein weiteres Kompensationselement angeordnet sein kann. Somit werden um den U-förmigen Stromleiter Metallklötze als Kompensationselemente angeordnet. Wichtig ist, dass das Metall keinen Kontakt zum eigentlichen Leiter hat, bzw. nicht vom Strom I durchflossen werden darf. Den gleichen Effekt, kann man auch bei dem Querschenkel des U-förmigen Stromleiters nutzen, somit besteht nicht die Gefahr, dass durch einen AC-Strom das Stützfeld des Sensorelements zu stark beeinflusst wird.

Die Querschnittsfläche der Kompensationselemente ist zumindest 50% bis zu 100% der Querschnittsfläche der Leiterabschnitte in Richtung des Wechselstroms I. Insofern ist der Querschnitt des bzw. der Kompensationselemente gleich oder kleiner als der Querschnitt des Leiterabschnitts bzw. der Leiterabschnitte ausgeformt, so dass die Kompensationselemente im Verhältnis nicht größer als die Struktur des Stromleiters sind und in einem Bauteil ohne signifikante Vergrößerung der Bauteildimension integriert werden können. Da das zu erzeugende Kompensationsfeld im Verhältnis klein gegenüber dem durch den Leiterabschnitt zu erzeugenden Messfeld ist, kann die Baugröße des Kompensationselementes entsprechend gleich groß oder kleiner als der Leiterabschnitt sein.

Das Kompensationselement und der Stromleiter sind galvanisch getrennt angeordnet. Dabei kann ein größtmöglicher Gestaltungsspielraum bezüglich Materialwahl, geometrische Gestalt und Abstand zu dem Stromleiter und zum Sensorelement erreicht werden. Zur Erzeugung eines effektiven Kompensationsfeldes ist insbesondere eine optimierte Länge des Kompensationselementes in Richtung des Stromverlaufs durch den Stromleiter erforderlich, der durch eine galvanisch getrennte Ausbildung einfach erreichbar ist. Vorteilhaft sind dazu das Kompensationselement und der Stromleiter mechanisch nichtleitend durch eine Stützstruktur wie eine Platine, Kunststoffhalter oder ähnliches lagefixiert miteinander verbunden oder in einem gemeinsamen Gehäuse integriert, z.B. mittels Gießharz oder Kunststoff umspritzt oder vergossen.

In einem nicht unter die beanspruchte Erfindung fallenden Vergleichsbeispiel kann das Kompensationselement auch als Stichabzweig des Stromleiters ausgebildet sein, der parallel dem Verlauf des Stromleiters folgt. Hierzu können bevorzugt bei zwei Leiterabschnitten die den Leiterabschnitten zugeordneten Stichabzweige alternierend zur Richtung des Wechselstroms I ausgerichtet sein. Eine derartige Ausformung bildet zwar konstruktive Randbedingung für die Definition von Gestaltung und räumlicher Anordnung der Kompensationselemente, ist allerdings fertigungstechnisch einfach einstückig mit dem Stromleiter mit einer Verbindungsbrücke als mechanische Verbindung zum Kompensationselement herstellbar. Es hat sich gezeigt, dass eine alternierende Ausrichtung der Stichabzweige, d.h. der Lage der Verbindungsbrücken bezüglich der Stromrichtung durch die Leiterabschnitte eine erhöhte Kompensationswirkung bietet. Bei höhenversetzten, gleichsinnig durchströmten Leiterabschnitte können die Kompensationselemente jeweils von einem Leiterabschnitt ausgehend antiparallel zueinander ausgerichtet sein. Bei einem U-förmigen Stromleiter können die beiden Kompensationselemente in die gleiche Schenkelrichtung der beiden parallelen Schenkel ausgerichtet sein, da die beiden Schenkel antiparallel vom Strom I durchflossen werden. Wichtig ist, dass die regelmäßig als Metallklötze ausgebildeten Kompensationselemente nichtleitend oder nur im Rahmen eines Stichabzweigs mit dem Stromleiter verbunden sind und nicht an der Stromführung teilnehmen. Je nach Geometrie und Nennstrom des Stromleiters können die in ihrem Querschnitt, Länge und Abstand zum Stromleiter ausgelegt werden. Die mechanische Verbindung und mechanische Fixierung der Kompensationselemente, die erfindungsgemäß als Metallklötze ausgeführt sind, sollte vorteilhaft über nichtleitenden Komponenten erfolgen. In einer vorteilhaften Ausführungsform können das Kompensationselement und der Stromleiter auf einem PCB (Printed Circuit Board - Elektronikplatine) angeordnet sein. Hierzu kann bevorzugt das Sensorelement auf derselben oder einer gegenüberliegenden Seite des PCBs angeordnet ist, und/oder das Kompensationselement und der Stromleiter in einem Gehäuse angeordnet sind. Dabei können Stromleiter und Kompensationselemente miteinander z.B. über nichtmagnetische Konstruktionselemente verbunden, z.B. miteinander verschraubt, geklemmt oder anderweitig fixiert werden, und /oder in einem Gehäuse relativ zueinander fixiert, z.B. in Kunststoff vergossen sein. So ist typischerweise der Stromleiter, beispielsweise in einer Ausführung als U-Leiter auf der Rückseite eines PCBs fixiert, wo auf der Vorderseite das Sensorelement platziert ist. Die Kompensationselemente können ebenfalls auf der Rückseite der Leiterplatte fixiert werden und / oder der Stromleiter, die Kompensationselemente und die PCB sind in einem gemeinsamen Gehäuse umfasst und vorteilhafterweise eingegossen.

Die Ausführung der Kompensationselemente bietet verschiedene Stell und Einflussgrößen, die entscheidend beeinflussen, ob sich eine Über-, Unter- oder vollständige Kompensation der Frequenzabhängigkeit ergibt. So ist der verwendete Werkstoff mit seinen Kenngrößen, der spezifische elektrische. Widerstand, Skin-Effekt Eindringtiefe und ebenso Abmessungen in Höhe und Breite aber auch in der Länge Optimierungsgrößen für die Kompensation. Die Abmessungen haben einen wesentlichen Anteil an aufgespannter Fläche zur Einkopplung des Wechselmagnetfeldes, aber auch an der Impedanz und damit der Stromamplitude des Kreisstrompfads der Wirbelströme. Ebenso sind die Position der Kompensationselemente relativ zum Sensorelement und der Abstand zum Stromleiter als wichtige und fertigungstechnisch variable Stellgröße je nach Einsatzgebiet optimierbar.

Nebengeordnet betrifft die Erfindung eine Verwendung eines erfindungsgemäßen

Stromsensors zur magnetfeldbasierten Messung eines elektrischen Stroms durch einen Stromleiter. Hierzu wird vorgeschlagen, dass frequenzabhängige Verzerrungen des Magnetfeldes durch ein, durch Induktion in zumindest einem leitfähigen Kompensationselement erzeugten, Kompensationsmagnetfeld kompensierbar sind. Somit ist eine kostengünstige und einfach zu realisierende Möglichkeit zur exakten Messung von sowohl DC- als auch AC-Strömen, auch bei überlagerten Strömen und transienten Schaltvorgängen gegeben. Bevorzugte Ausgestaltungen des Stromsensors werden anhand von in Figuren dargestellten Ausführungsformen nachfolgend noch näher beschrieben.

## ZEICHNUNGEN

Weitere Vorteile ergeben sich aus den vorliegenden Zeichnungen und den zugehörigen Zeichnungsbeschreibungen. In den Zeichnungen sind Ausführungsbeispiele der Erfindung dargestellt. Die Zeichnungen, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:

**Fig. 1**      eine perspektives Darstellung eines Stromsensors mit U-förmigen Stromleiter des Stands der Technik;

**Fig. 2**      eine Draufsicht auf einen U-förmigen Stromleiter des Stands der Technik;

**Fig. 3**      eine schematische Darstellung eines Stromsensors mit höhenversetzten Leiterabschnitten des Stands der Technik;

**Fig. 4**      eine schematische Darstellung eines geschirmten Stromsensors mit höhenversetzten Leiterabschnitten des Stands der Technik;

**Fig. 5a-d**      eine Draufsicht auf ein erstes, zweites und drittes Ausführungsbeispiel eines Stromsensors mit U-förmigem Stromleiter, wobei die Fig. 5a-5c erfindungsgemäße Ausführungsbeispiele zeigen und Fig. 5d ein nicht erfindungsgemäßes Vergleichsbeispiel zeigt;

**Fig. 6a-c**      Stromdichte und Magnetfeldverteilung des in Fig. 5 dargestellten Stromsensors in verschiedenen Ausführungen;

**Fig. 7**      simuliertes Gradientenfeld bei verschiedenen Abständen der Stromleiter bei den verschiedenen Ausführungen aus Fig. 6;

**Fig. 8**      eine Draufsicht auf ein nicht erfindungsgemäßes viertes Ausführungsbeispiel eines Stromsensors mit höhenversetzten Leiter-

Fig. 9      eine Draufsicht auf ein nicht erfindungsgemäßes fünftes Ausführungsbeispiel eines Stromsensors mit höhenversetzten Leiterabschnitten und magnetischer Schirmung;

Fig. 10     Stromdichte und Magnetfeldverteilung des in Fig. 9 dargestellten Ausführungsbeispiels;

Fig. 11     Signalverlauf eines Schaltvorgang des in Fig. 9 dargestellten Stromsensors;

Fig. 12     eine perspektivische Darstellung eines sechsten Ausführungsbeispiels eines erfindungsgemäßen Stromsensors:

Fig. 13     eine perspektivische Darstellung eines nicht erfindungsgemäßen siebten Ausführungsbeispiels eines Stromsensors:

Fig. 14     eine schematische Darstellung eines achtes Ausführungsbeispiels eines erfindungsgemäßen Stromsensors.

In den Figuren sind gleichartige Elemente mit gleichen Bezugszeichen beziffert.

Die Figuren zeigen lediglich Beispiele und sind nicht beschränkend zu verstehen.

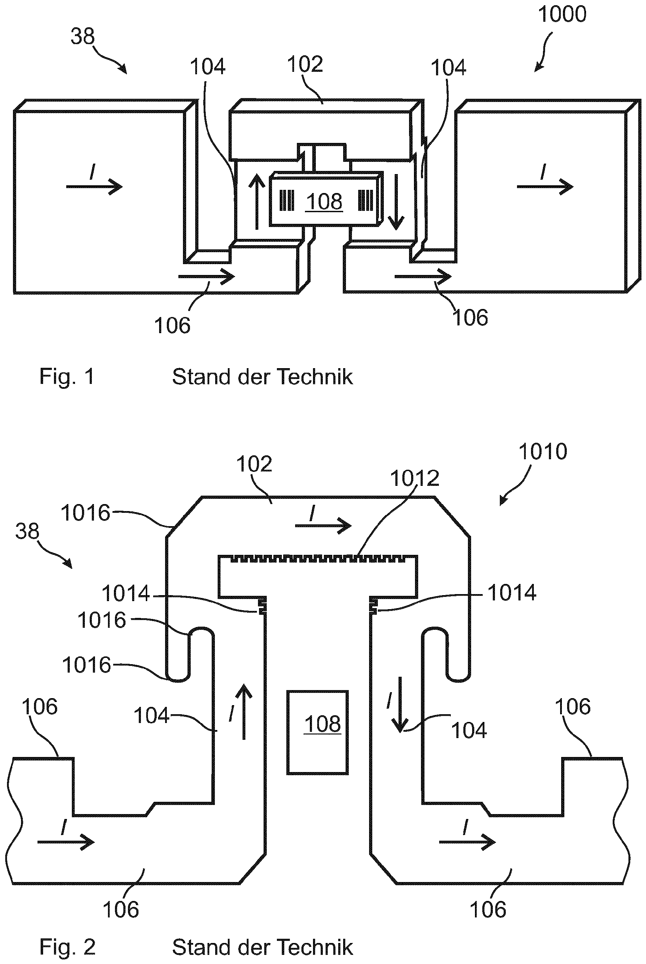

In der Fig. 1 ist eine aus der WO 2014/001473 A1 bekannter erster Stromsensor 1000 des Stands der Technik dargestellt. Die Stromsensor 1000 weist ein Sensorelement 108 und einen U-förmigen Stromleiter 38 auf, bei dem der strommessaktive Schenkel 104 in einer z-Richtung gegenüber dem strommessparasitären Querschenkel 102 und der Anschlussleitung 106 zurückversetzt sind, so dass parasitäre Magnetfeldkomponenten im Wesentlichen rechtwinklig eine magnetfeldneutrale Ausrichtungsebene der Sensorstruktur des Sensorelements 108 durchdringen. Durch die in z-Richtung versetzte Anordnung von den Schenkeln 104 gegenüber den Anschlussleitungen 106 und dem Querschenkel 102 wird erreicht, dass parasitäre Magnetfeldkomponenten unterdrückt oder lediglich durch eine magnetfeldneutrale Ausrichtungsebene treten, während die zu erfassenden strommessaktiven Magnetfeldkomponenten durch die magnetfeldsensitive Ausrichtungsebene des Sensorelements 108 treten. Die Messung von höherfrequenten Strömen über 100 Hz, bevorzugt über 500 Hz, insbesondere über 1 kHz, und im speziellen über 10 kHz leidet darunter, dass aufgrund von Skin- und Proximity-Effekt das Wechselmagnetfeld zwischen den beiden Leiterschnitten 104 konzentriert wird, wodurch eine deutlich nichtlineare Abweichung des Signalwertes von der Stromgröße erfolgt, die nur mit aufwändigen Filterschaltungen kompensiert werden kann.

Dahingehend zeigt Fig. 2 ein verbessertes Layout eines U-förmigen Stromleiters 38, der für eine AC-Messung optimiert ist. Der Stromleiter 38 weist hierzu AC-Abstimmungsstrukturen 1012 im Querschenkel 102 und Abstimmstrukturen 1014 in den Leiterabschnitten 104 auf. Daneben sind Ecken und Kanten 1016 abgerundet, dies dient vornehmlich einer thermischen Optimierung des Betriebsverhaltens. Dabei kann der Stromsensor 1000 mit U-Stromleiter 38 eine relativ komplexe Geometrie für ausgewählte Anwendungsfälle haben, und kann in engen, vorbekannten Frequenzbereichen eine Kompensation von Skin- und Proximity-Effekt ermöglichen,

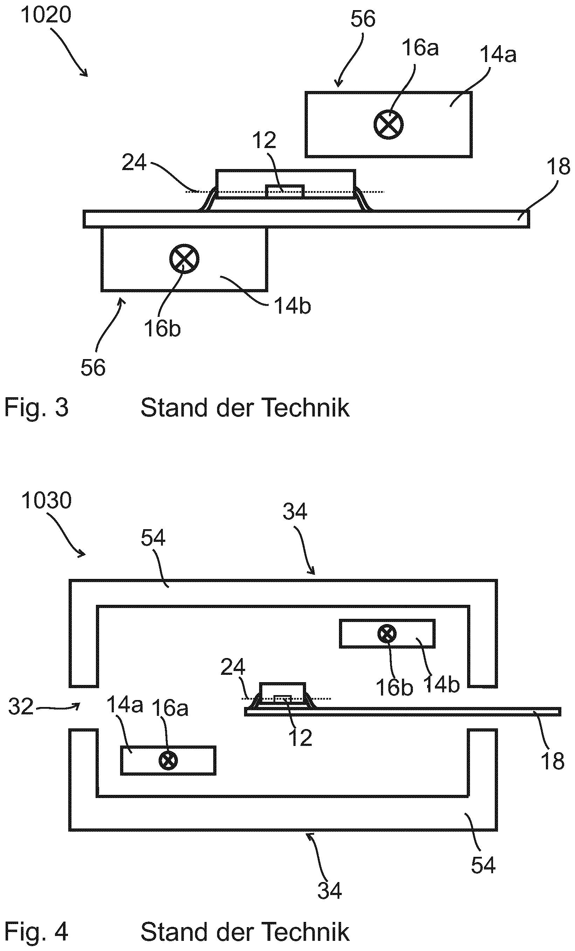

In der Fig. 3 ist eine aus der WO 2019/072421 A1 bekannter zweiter Stromsensor 1020 des Stands der Technik dargestellt. Ein Stromleiter 56 ist in zwei Leiterabschnitte 14a, 14b aufgeteilt, wobei in den Leiterabschnitten14a, 14b ein entsprechender Stromteil 16a und Stromanteil 16b mit einer gleichen Stromflussrichtung fließt. Zwischen beiden Leiterabschnitten 14a, 14b ist ein Sensorelement 12 auf einer PCB-Folie 18 platziert, wobei das Sensorelement 12 als Gradientensorelement ausgebildet ist, das eine Magnetfeldstärkedifferenz einer Tangentialkomponenten des Magnetfelds in einer Messebene 24 misst. Hierbei ist die Messebene 24 so definiert, dass in ihr magnetfeldempfindliche Widerstände des Sensorelements 12 liegen, die bzgl. Vektorkomponenten des Magnetfelds, die parallel in der Messebene 24 liegen (Tangentialkomponenten) empfindlich sind. Weiterhin sind beide Leiterabschnitte 14a, 14b bezüglich der Messebene 24 antiparallel höhenversetzt. Bei der Messung hochfrequenter Ströme bilden sich aufgrund von Skin- und Proximity-Effekt nichtlineare Verzerrungen des Messmagnetfelds am Ort des Sensorelementes 12, der eine deutliche Abweichung der Sensorsignale bei gleichen Stromstärken gegenüber dem DC-Fall hervorruft, daher ist der Stromsensor 1020 nur in eng begrenzten Frequenzbereichen für eine exakte Strommessung einsetzbar.

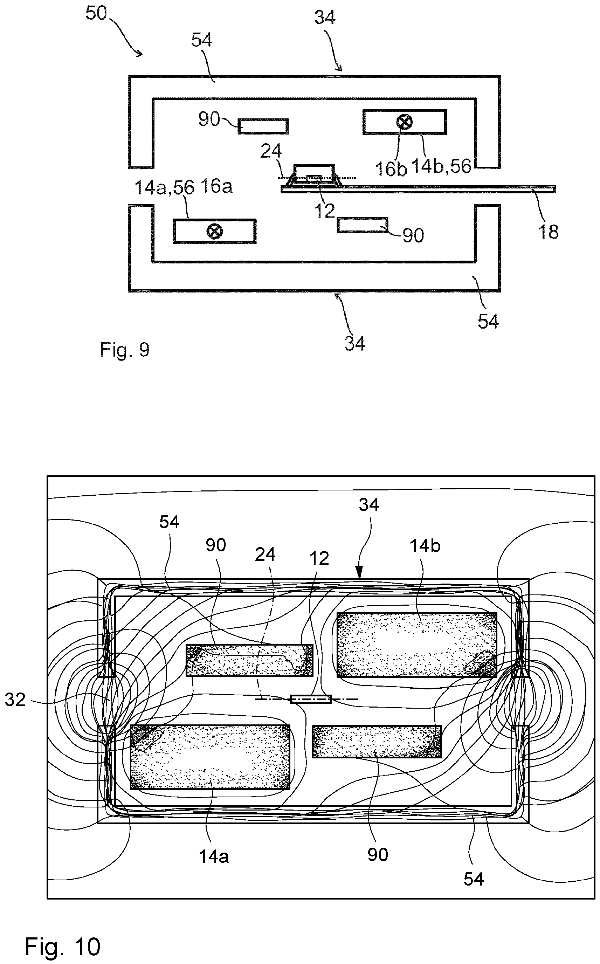

Die in der Fig. 3 dargestellte Konfiguration des Stromsensors 1020 ist in der Fig. 4 als ein weiterer, aus der WO 2019/072421 A1 bekannter vierter, weiterentwickelter Stromsensor 1030 dargestellt. Diese Stromsensoranordnung umfasst zwei Leiterabschnitte 14a, 14b und ein Sensorelement 11. Zwischen beiden Leiterabschnitten 14a, 14b ist das Sensorelement 11 angeordnet, in dem das magnetfeldempfindliche Sensorelement 12 das Gradientenfeld erfasst und auf der PCB-Folie 18 angeordnet ist. Beide Leiterabschnitte 14a, 14b sind gegenüber der Messebene 24 symmetrisch antiparallel höhenversetzt, in der die Magnetfeldstärkedifferenz gemessen wird. Der Stromanteil 16a und Stromanteil 16b fließen in den Leiterabschnitten 14a, 14b in die gleiche Richtung. Außerhalb der Stromsensoranordnung sind zwei rechteckige Schirmungsabschnitte 54 als magnetische Abschirmung 34 ausgebildet, die zwei Schlitze 32 aufweisen, und die entsprechend Fig. 9 Störeinflüsse abschirmen. Insofern ist der Stromsensor 1030 gegenüber äußeren Streufeldern geschützt und die EMC-Robustheit erhöht. Dennoch verbleiben die zum Stromsensor 1020 der Fig. 3 angesprochene Probleme eines frequenzabhängigen Sensorsignals, der eine Breitbandmessung von Strömen verschiedener Frequenzlagen erschwert.

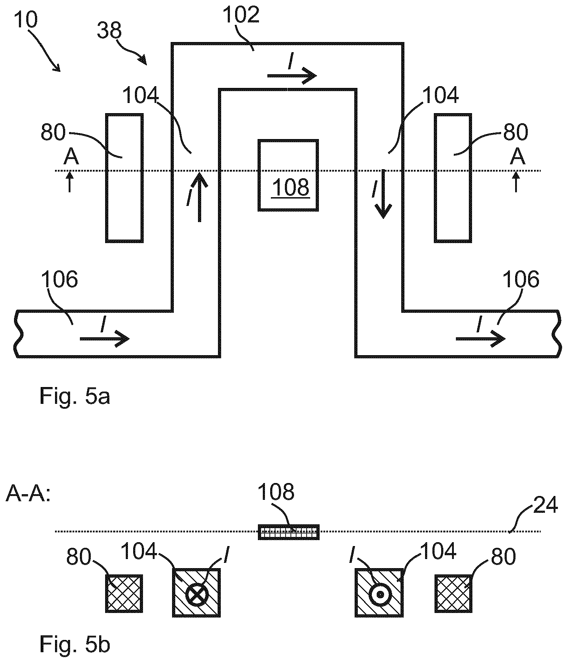

In den Figuren 5a und 5b ist eine erste Ausführungsform 10 eines erfindungsgemäßen Stromsensors in Draufsicht und Schnittdarstellung gezeigt. Fig. 5a zeigt eine Draufsicht auf den Stromleiter 38 und Fig. 5b zeigt eine Schnittdarstellung entlang der in Fig. 5a eingezeichneten Schnittlinie A-A. Der Stromleiter 38 ist U-förmig und umfasst zwei Anschlussleitungen 106 zum Einkoppeln und Abführen des zu messenden Strom I. Pfeile symbolisieren die Stromrichtung im DC-Fall. Der Stromleiter 38 umfasst einen Querschenkel 102 und zwei Längsschenkel als Leiterabschnitte 104, die ein Messmagnetfeld hervorrufen, dessen Gradient vom symmetrisch dazwischen angeordneten Sensorelement 108 erfassbar ist. Zur Kompensation des frequenzabhängigen Skin- und Proximity-Effekt sind in einer Schnittebene A-A radial beabstandet zu den Leitungsabschnitten 104 zwei metallische Klötze als Kompensationselemente 80 angeordnet. In diesen Kompensationselementen 80 werden durch Induktion Wirbelströme erzeugt, die ein Kompensationsfeld hervorrufen, das im Bereich des zur Ebene der Leiterabschnitte 104 und Kompensationselemente 80 höhenversetzten Sensorelements 108 in dessen Messebene 24 einer frequenzabhängigen nichtlinearen Feldverzerrung entgegenwirkt und somit ein ähnliches Messsignal bei gleichen Stromstärken wie im DC-Fall hervorruft. Somit kann das Signalverhalten über einen weiten Frequenzbereich bei gleichen Nennströmen homogenisiert und Auswirkungen von Skin- und Proximity-Effekt kompensiert werden.

Die eigentlich störenden Effekte (Skin und Proximity) werden durch Anordnung zusätzlichen Metalls der Kompensationselemente 80 genutzt um das resultierende Wechselmagnetfeld oder transiente Magnetfeld von der Frequenz des Stroms unabhängig zu machen. Dabei soll idealerweise die Stromverteilung und insbesondere das Magnetfeld denen des DC-Falles (Gleichstrommessung) entsprechen.

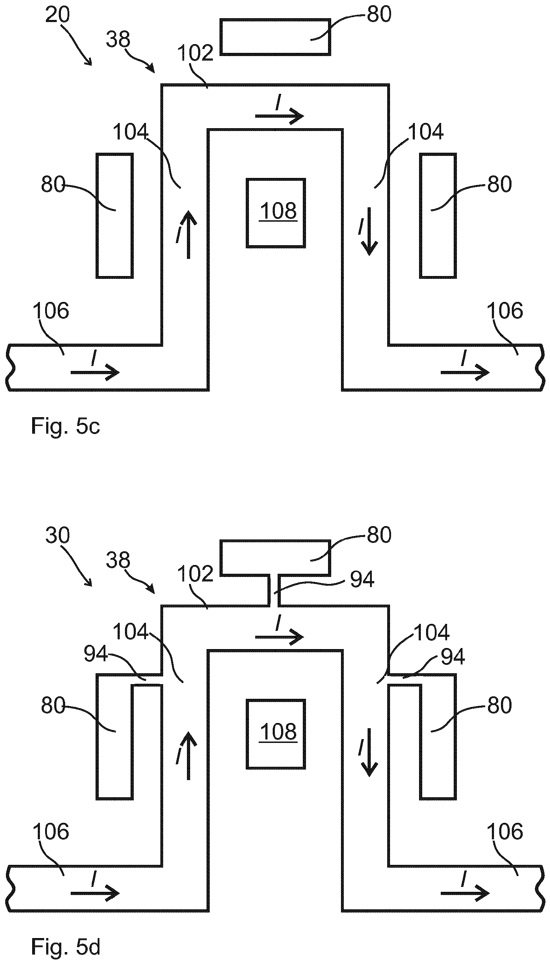

Die in der Fig. 5c dargestellte zweite Ausführungsform 20 ist gegenüber der ersten Ausführungsform 10 entlang des Querschenkels 102 ebenfalls ein Kompensationselement 80 angeordnet. Dieses dient dazu, das vom Querschenkel 102 erzeugte Störmagnetfeld im gleichen Maße wie das Messmagnetfeld der Leiterabschnitte 104 zu kompensieren, um einen sekundären frequenzabhängigen Einfluss des parasitären Störfeldes des Querschenkels 102 zu kompensieren. Gleichwohl können auch im Bereich der Anschlussleitungen 106 weitere Kompensationselemente vorgesehen sein.

Weiter zeigt Fig. 5d eine Draufsicht auf eine nicht erfindungsgemäße dritte Ausführungsform 30, die sich von der zweiten Ausführungsform 20 dadurch unterscheidet, dass die Kompensationselemente 80 einstückig mit dem Stromleiter 38 über Verbindungsbrücken 94 angeschlossen sind. Die Verbindungsbrücken 94 sind beispielsweise zusammen mit den Kompensationselemente 80 und dem Stromleiter 38 als Stanzbauteil ausgeformt. Alternativ können die Verbindungsbrücken 94 auch nachträglich beispielsweise angeschweißt oder angelötet werden und stellen eine galvanische Verbindung ohne Stromfluß zwischen Stromleiter 38 und Kompensationselement 94 dar. Alternativ kann die Verbindungsbrücke 94 aus einem nichtleitenden Material wie Kunststoff bestehen. Vorteilhaft können die Verbindungselemente 94 in einer Stromlaufrichtung an alternierenden Enden der Kompensationselemente 80 angeordnet werden, wie dies bei den Leiterabschnitten 104 zugeordneten Kompensationselementen 80 der Fig. 5d der Fall ist. Denkbar ist auch eine Anordnung der Verbindungsbrücke 94 in der Mitte des Kompensationselementes 80, wie am Querschenkel 102 gezeigt, möglich.

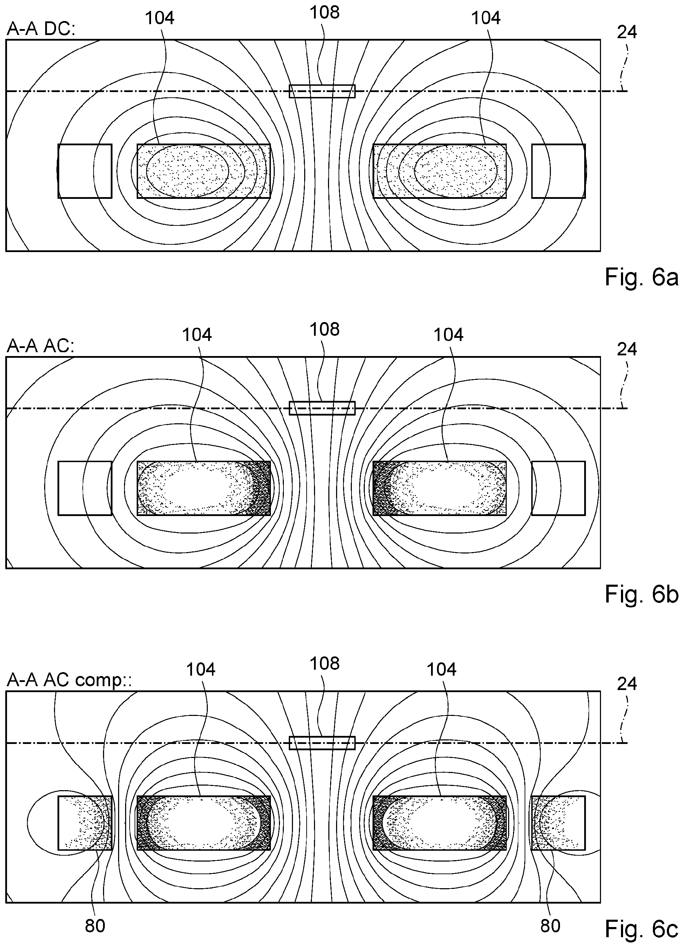

Die Figuren 6a bis 6c zeigen anhand einer elektromagnetischen Simulation die Stromverteilung und eine Darstellung von Flusslinien des magnetischen Wechselfeldes im Querschnitt A-A der Fig. 5b durch einen U-förmigen Stromleiter mit parallelen Leiterabschnitten 104, die höhenversetzt zur Messebene 24 in einer parallelen darunterliegenden Ebene zum Gradientensensorelement 108 angeordnet ist. Hierbei zeigt Fig. 6a einen Gleichstromvorgang (DC Fall). In Fig. 6b ist ein Wechselstrom behafteter Strom AC-Fall ohne Kompensation gezeigt, dabei ist eine potentielle Lage von Kompensationselemente 80 schemenhaft angedeutet. Deutlich ist die Veränderung der Stromdichteverteilung und des Magnetfeldes der beiden Leiterabschnitte 104, die beide näher zusammenrücken, gegenüber dem Gleichstromfall erkennbar. In Fig. 6c ist die Messung eines Wechselstroms mit optimierter Lage und Gestalt von Kompensationselementen 80 dargestellt (AC-Fall mit Kompensation). Dabei sind die Kompensationselemente 80 aus Kupfer und die Leiterabschnitte 104 aus Aluminium ausgebildet Ohne die Kompensation zeigt sich in Fig. 6b deutlich die Konzentration des Stroms in der Mitte, was zu einer Erhöhung des Gradientenfeldes im Vergleich zu einem DC-Strom führt. Im Fall der Kompensation in Fig. 6c zeigt sich, dass ein Teil des Stroms nach außen zu den Kupferklötzen der Kompensationselemente 80 gezogen wird. Das dazu führt, dass am Sensorelement 108 praktisch das gleiche magnetische Feld wie im DC-Fall nach Fig. 6a einstellt und somit die nichtlinearen Verzerrungseffekte von Skin- und Proximity-Effekt kompensiert sind.

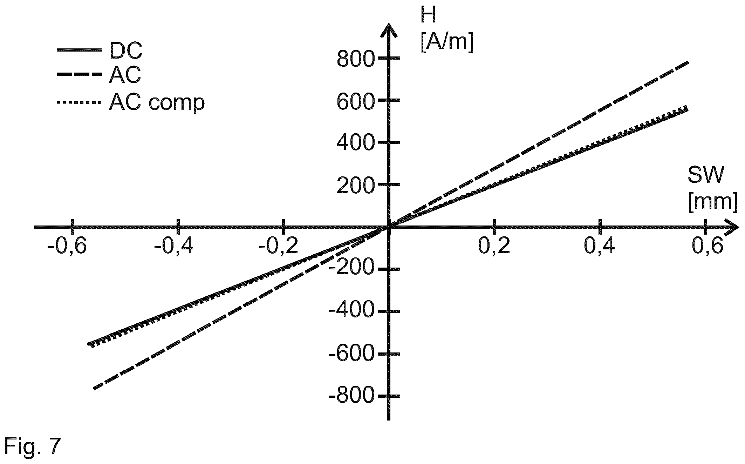

Fig. 7 stellt eine Untersuchung eines gemessenen Magnetfelds abhängig von einer Basisbreite des Sensorelements 108 in drei Fällen DC, AC und AC mit Kompensation (AC comp) bei identischer Nennstromstärke I dar: Auf der X-Achse ist die Basisbreite SW des Sensorelements 108 eingezeichnet, die mit dem Abstand zur Bestimmung des Gradientenfeldes korreliert, auf der Y-Achse die Größe des gemessenen magnetischen Feldstärkegradienten. Im Falle einer Gleichstrommessung (DC-Fall) und im Falle einer optimierten Kompensation (AC comp-Fall) hat die Größe der Basisbreite des Sensorelements 108 praktisch keinen Einfluss auf den Messwert des Gradientenfeldes. Dies weist darauf hin, dass das Kompensationsfeld eine identische Feldkonfiguration im kompensierten AC-Fall wie im DC-Fall bereitstellt. Ohne Kompensationselemente 80 (AC-Fall) weicht das Gradientenfeld bei zunehmender Sensor-Basisbreite SW deutlich vom DC-Fall ab.

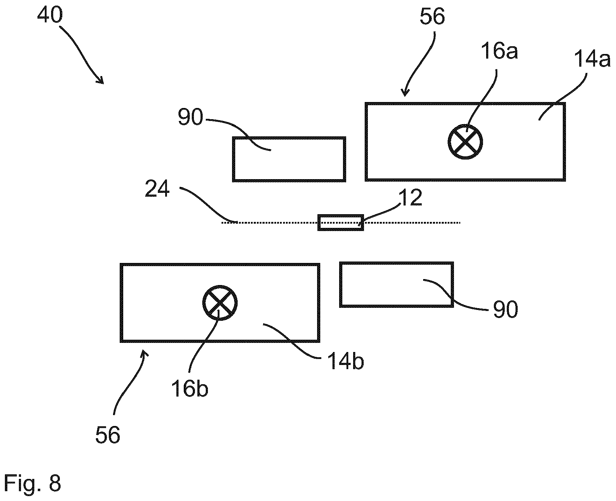

Fig. 8 ist schematisch eine nicht erfindungsgemäße Ausführungsform 40 eines Stromsensors mit höhenversetzten Leiterabschnitten 14a, 14b dargestellt. Grundsätzlich entspricht Aufbau und Funktion des Stromsensors 40 dem in der Fig. 3 dargestellten Stromsensor 1020 des Stands der Technik. Zudem sind zwei Kompensationselemente 90 vorgesehen, die komplementär höhenversetzt zu den Leiterabschnitten 14a, 14b zur Messebene 24 angeordnet sind. Die Querschnittsfläche der Kompensationselemente 90 beträgt rund 35% der Querschnittsfläche der Leiterabschnitte 14a, 14b und der radiale Abstand des Schwerpunktes der Kompensationselemente 80 zum Sensorelement 12 ist deutlich geringer als der radiale Abstand des Schwerpunktes der Leiterelemente 14a, 14b.

Fig. 9 zeigt aufbauend auf der vierten Ausführungsform 40 der Fig. 8 eine nicht erfindungsgemäße fünfte Ausführungsform 50, die ebenfalls grundsätzlich dem in Fig. 4 dargestellten Stromsensor 1030 des Stands der Technik entspricht. Die Anordnung der Kompensationselemente 90 folgt im Wesentlichen der in Fig. 8 dargestellten Konfiguration. Unabhängig von der magnetischen Schirmung 54 bewirken die Kompensationselemente 90 ein magnetisches Gesamtwechselfeld, das einer DC-Strommessung entspricht.

Fig. 10 stellt eine Abbildung einer Stromdichteverteilung und des Magnetfeldes im AC-Betrieb des in Fig. 9 dargestellten Stromsensors 50 dar. Deutlich sind der Wirbelstrom und das Kompensationsfeld in den Kompensationselementen 90 erkennbar, die unabhängig von der magnetischen Schirmung 54 am Sensorelement 12 eine frequenzunabhängige Magnetfeldverteilung bewirkt.

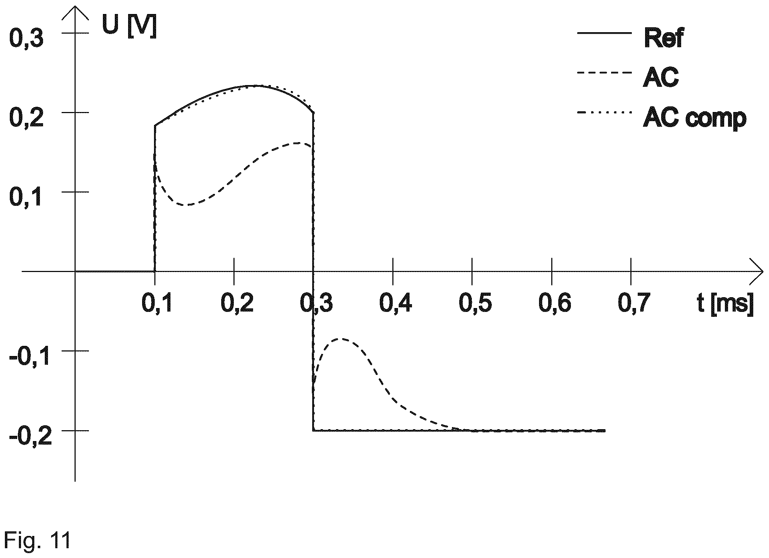

In dem Diagramm der Fig. 11 ist ein Ausgangssignalverlauf des Stromsensors 50 der Fig. 9 dargestellt. Dabei wird ein DC-Strom in einer kurzen zeitlichen Abfolge geschaltet, und der Ausgangsspannungs-Signalverlauf des Sensorelements 12 über die Zeit aufgezeichnet. In der kompensierten Variante (AC comp.) folgt der Ausgangssignalverlauf des Sensorelements 12 exakt der Referenzkurve Ref, wobei in einer unkompensierten Variante, wie in Fig. 4 durch Stromsensor 1030 dargestellt, ein deutliches Unterschwingen aufgrund des transienten Sprungs mit einer Vielzahl von Frequenzen und entsprechenden Verzerrungen durch die Gegeninduktivität des Stromleiters 56 auftritt

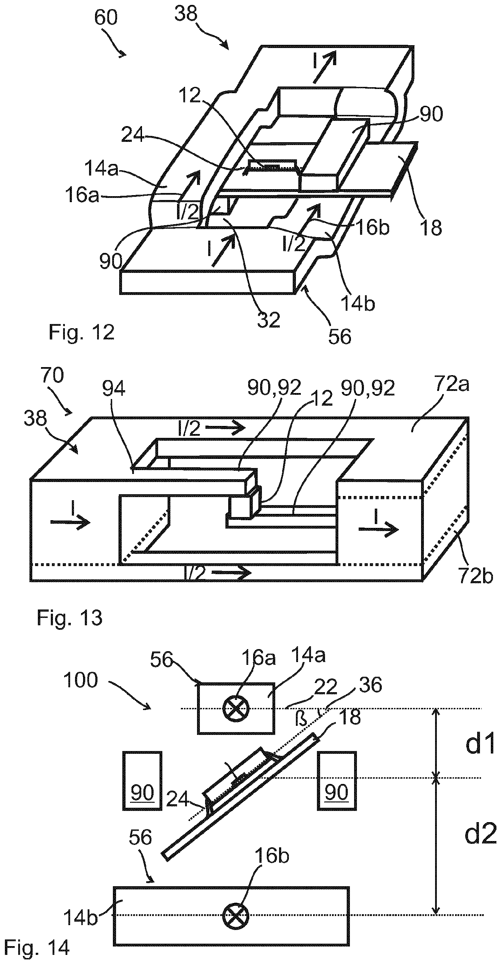

Fig. 12 stellt eine sechste Ausführungsform 60 einer Stromsensoranordnung dar. Der Stromleiter 56 ist als einstückiges Stanzbiegeteil ausgebildet, der in zwei Teile aufgeteilt und den Schlitz 32 aufweist, in dem das Sensorelement 11 auf der PCB-Folie 18 angeordnet ist. Dabei sind die Schlitzabschnitte als Leiterabschnitte 14a, 14b ausgebildet. Im Stromleiter 56 fließt ein Primärstrom I, der in zwei Stromanteile 16a, 16b von den Leiterabschnitten 14a, 14b aufgeteilt und in dieselbe Richtung bezüglich des magnetfeldempfindlichen Sensorelements 12 geführt wird. Infolge einer flexiblen PCB-Folie 18 kann das magnetfeldempfindliche Sensorelement 12 räumlich variabel in den Schlitz 32 des Stromleiters 56 eingebracht werden. Zwei Kompensationselemente 90 sind jeweils komplementär zu den Leiterabschnitten 14a, 14b und in einer im Wesentlichen parallelen Anordnung derart angeordnet, dass diese ein geeignetes Kompensationsfeld für einen weiten Frequenzbereich angeordnet. Die Kompensationselemente 90 können beispielsweise mittels Kunststoffhalterungen temporär am Stromleiter 38 befestigt und in einem Gehäuse mittels eines fließfähigen Kunststoff oder Gießharz fest eingegossen sein.

In der Fig. 13 ist eine nicht erfindungsgemäße siebte Ausführungsform 70 einer Stromsensoranordnung dargestellt. Im Gegensatz zur Fig. 12 ist der Stromleiter als zwei miteinander verbundene Stanzbiegeteile ausgebildet. Das Stanzbiegeteil 72a und das Stanzbiegeteil 72b sind zusammengelötet, zusammengenietet oder geschweißt, so dass beide Stanzbiegeteile miteinander verbunden sein können, und ggf. durch Distanzstücke, die einen räumlichen Abstand zur Messebene 24 definiert, beabstandet. Hierdurch können die Stanzbiegeteile 72a, 72b als zwei Leiterabschnitte 14a, 14b ausgeformt sein. Da beide Stanzbiegeteile 72a, 72b antiparallel zueinander ausgebildet sind, kann fakultativ (nicht dargestellt) das magnetfeldempfindliche Sensorelement 12 zu beiden Stanzbiegeteilen gekippt, vorzugsweise um 45° zu beiden Stanzbiegeteilen angeordnet sein, um die Messebene zum Magnetfeldverlauf anzupassen. Damit kann der Primärstrom I gemessen werden.

Die Kompensationselemente 90 können als verlängerte Finger bzw. Stichabzweige 92 mit integrierten Verbindungsbrücke 94 einstückig mit dem Stanzbiegeteil 72a, 72b ausgeformt sein. Dabei sind die Kompensationselemente 94 alternierend, in diesem Fall antiparallel zueinander bezüglich einer Stromrichtung durch den Stromleiter 38 angeordnet, wodurch eine optimierte Kompensation on frequenzbedingten Verzerrungen erreicht werden kann.

In der Fig. 14 ist eine achte Ausführungsform einer Stromsensoranordnung 100 dargestellt. Der Stromleiter 56 ist in zwei Leiterabschnitte 14a, 14b mit unterschiedlich großem Querschnitt aufgeteilt, die in einer gemeinsamen Leiterebene 22 liegen. In beiden Leiterabschnitten 14a, 14b ist ein entsprechend des Querschnitts unterschiedlicher Stromanteil 16a und 16b geführt, der eine gleiche Richtung und eine ungleiche Größe aufweist. Das auf der PCB-Folie 18 angeordnete Sensorelement 11 ist in einem Winkel β 36 zur Leiterebene 22 angeordnet, d.h. das magnetfeldempfindliche Sensorelement 12 ist zur Leiterebene 22 gekippt. Vorzugsweise ist der Winkel β 36 in einem Bereich von 30° bis 60°, vorzugsweise 45° gewählt. Falls der Stromanteil 16a kleiner als der Stromanteil 16b ist, können beide Leiterabschnitte 14a, 14b gegenüber der Messebene 24 asymmetrisch angeordnet werden. Mit anderen Worten kann der Abstand zwischen der Messebene 24 und dem Leiterabschnitt 14a geringer als der Abstand zwischen der Messebene 24 und dem Leiterabschnitt 14b ausgebildet werden, wodurch die Magnetfeldstärkedifferenz vom magnetfeldempfindlichen Sensorelement 12 genau gemessen werden kann.

Dabei ist eine Strommessung bezüglich der achten Ausführungsform einer Stromsensoranordnung 100 dargestellt. Beide Leiterabschnitte 14a, 14b sind in einer gemeinsamen Leiterebene angeordnet, wobei die Leiterabschnitte 14a, 14b den Stromanteil 16a und Stromanteil 16b aufweisen, die eine ungleiche Stromgröße aufweisen, und in eine gleiche Stromflussrichtung geführt sind. Die Messebene 24 ist zu beiden Leiterabschnitten 14a, 14b um einen Winkel β gekippt, wobei infolge der Stromasymmetrie beide Leiterabschnitte 14a, 14b gegenüber der Messebene 24 asymmetrisch angeordnet sind. In dieser Ausführungsform ist der Abstand d1 zwischen dem Leiterabschnitt 14a und der Leiterebene 24 kleiner als der Abstand d2 zwischen dem Leiterabschnitt 14b und der Leiterebene 22 ausgebildet. Beide hervorgerufene Magnetfelder 60a, 60b schneiden sich an der Messebene 24. Somit kann der magnetfeldempfindliche Gradientensensor die Differenz beider Magnetfelder gemessen werden. Eine optimale asymmetrische Ausrichtung und die verschiedenen Abstände zu den Leiterabschnitten können bereits im Auslegungsvorfeld mittels einer computergestützten Feldsimulation oder empirisch durch eine mechanische Kalibrierung für einen angestrebten Strommessbereich ermittelt werden. Mittels Kompensationselemente 90, die in einer rechtwinkligen Ebene zur durch die Leiterabschnitte 14a, 14b aufgespannten Ebene liegen, kann das frequenzabhängige Messverhalten kompensiert werden.

**Bezugszeichenliste**

| | |
|---|---|
| 10 | Erstes Ausführungsbeispiel eines Stromsensor |
| 12 | Sensorelement |
| 14a | Leiterabschnitt a |
| 14b | Leiterabschnitt b |
| 16a | Stromanteil a |
| 16b | Stromanteil b |
| 18 | PCB-Folie |
| 20 | Zweites Ausführungsbeispiel eines Stromsensor |
| 22 | Leiterebene |
| 24 | Messebene |
| 30 | Drittes Ausführungsbeispiel eines Stromsensor |
| 32 | Schlitz |
| 34 | magnetische Abschirmung |
| 36 | Winkel β |
| 38 | Stromleiter |
| 40 | Viertes Ausführungsbeispiel eines Stromsensor |
| 50 | Fünftes Ausführungsbeispiel eines Stromsensor |
| 54 | Schirmungsabschnitt |
| 56 | Stromleiter |
| 60 | Sechstes Ausführungsbeispiel eines Stromsensor |
| 70 | Siebtes Ausführungsbeispiel eines Stromsensor |
| 72a | U-förmiger Stanzbiegeteil a |
| 72b | U-förmiger Stanzbiegeteil b |
| 80 | Kompensationselement |
| 90 | Kompensationselement |
| 92 | Stichabzweig |
| 94 | Verbindungsbrücke des Stichabzweigs |
| 100 | Achtes Ausführungsbeispiel eines Stromsensor |
| 102 | Querschenkel |
| 104 | Leiterabschnitt, Schenkel |
| 106 | Anschlussleitung |
| 108 | Sensorelement |
| 1000 | Erster Stromsensor des Stands der Technik |
| 1010 | Stromleiter für Stromsensor des Stands der Technik |
| 1012 | AC-Abstimmungsstrukturen im Querschenkel |
| 1014 | AC-Abstimmungsstrukturen im Längsschenkel |
| 1016 | Abrundungen und Abkantungen des Stromleiters |
| 1016 | Abrundungen, Abwinkelungen der Leiterführung |
| 1020 | Zweiter Stromsensor des Stands der Technik |
| 1030 | Dritter Stromsensor des Stands der Technik |
| d1 | Abstand zwischen Leiterabschnitt a und Messebene |
| d2 | Abstand zwischen Leiterabschnitt b und Messebene |
| I | zu messender Wechselstrom |

**Patentansprüche**

1. Stromsensor (10, 20, 30, 40, 50, 60, 70, 100) zur magnetfeldbasierten Strombestimmung eines Wechselstromes I durch einen Stromleiter (38, 56) auf Basis eines magnetfeldempfindlichen Sensorelements (12, 108), wobei das Sensorelement (12, 108) räumlich benachbart zum Stromleiter (38,56) zur Erfassung eines durch den Wechselstrom I im Stromleiter (38, 56) hervorgerufenen Magnetfeldes angeordnet ist, **dadurch gekennzeichnet, dass** zumindest ein als leitfähiges Kompensationselement (80, 90) ausgebildeter Metallklotz mit einer Querschnittsfläche von zumindest 50 % bis 100% der Querschnittsfläche des Stromleiter (38, 56), galvanisch getrennt vom Fluss des Wechselstroms I durch den Stromleiter (38, 56) und derart räumlich benachbart zum Sensorelement (12, 108) und zum Stromleiter (38, 56) zur Kompensation von frequenzabhängigen Verzerrungen des Magnetfeldes mittels eines sich durch Induktion von Wirbelströmen ergebenden Kompensationsmagnetfelds angeordnet ist, so dass störende Einflüsse frequenzabhängiger Stromdichteeffekte des Stromleiters (38, 56) auf das Sensorelement (12 108) durch das Kompensationsmagnetfeld des Kompensationselements (80, 90) kompensiert werden.

2. Stromsensor (10, 20, 30, 40, 50, 60, 70, 100) nach Anspruch 1, **dadurch gekennzeichnet, dass** das Kompensationselement (80, 90) eine Leitfähigkeit aufweist, die größer oder gleich der Leitfähigkeit des Stromleiters (38, 56) ist, wobei bevorzugt das Kompensationselement (80, 90) aus Kupfer, Aluminium oder Silber besteht.

3. Stromsensor (10, 20, 30, 40, 50, 60, 70, 100) nach einem der vorhergehenden Ansprüche, **dadurch gekennzeichnet, dass** der Stromleiter (38, 56) zwei Leiterabschnitte (14a, 14b, 104) umfasst, wobei das Sensorelement (12, 108) zwischen den beiden Leiterabschnitten (14a, 14b, 104) angeordnet ist, und bevorzugt als Gradientensensor ausgebildet ist, und wobei zumindest ein, bevorzugt zwei Kompensationselemente (80,90) im Wesentlichen entlang eines sensoraktiven Teilabschnitts dem Verlauf der beiden Leiterabschnitte (14a, 14b, 104) folgen.

4. Stromsensor (10, 20, 30, 40, 50, 60, 70, 100) nach Anspruch 3, **dadurch gekennzeichnet, dass** sich der durch die Leiterabschnitte (14a, 14b) fließende Wechselstrom I des Stromleiters (56) bezogen auf eine Querschnittsebene durch die Leiterabschnitte (14a, 14b) aufteilt und in gleicher Richtung fließt.

5. Stromsensor (10, 20, 30, 40, 50, 60, 70, 100) nach Anspruch 4, **dadurch gekennzeichnet, dass** die Leiterabschnitte (14a, 14b) des Stromleiters (56) bezüglich einer Messebene (20) des magnetfeldempfindlichen Gradientensensors (12) höhenversetzt sind, insbesondere, dass ein Leiterabschnitt (14b) unterhalb und ein Leiterabschnitt (14a) oberhalb der Messebene (24) geführt ist, wobei bezogen auf das Sensorelement (12) zumindest zwei Kompensationselemente (90) und das Sensorelement (12) auf einer Ebene angeordnet sind, die abgewinkelt, insbesondere die rechtwinklig, zu einer durch die Leiterabschnitte (14a, 14b) und das Sensorelement (12) verlaufenden Ebene verläuft, und wobei weiterhin bevorzugt ein radialer Abstand der Kompensationselemente (90) zum Sensorelement (12) gleich oder kleiner als ein radialer Abstand der Leiterabschnitte (14a, 14b) zum Sensorelement (12) ist.

6. Stromsensor (10, 20, 30, 40, 50, 60, 70, 100) nach Anspruch 3, **dadurch gekennzeichnet, dass** der durch die Leiterabschnitte (104) des Stromleiters (38) fließende Wechselstrom I bezogen auf eine Querschnittsebene durch die Leiterabschnitte (104) in entgegengesetzte Richtung fließt.

7. Stromsensor (10, 20, 30, 40, 50, 60, 70, 100) nach Anspruch 6, **dadurch gekennzeichnet, dass** die Leiterabschnitte (104) des Stromleiters (38) und zumindest zwei Kompensationselemente (80) in einer Messebene (24) des Sensorelements (108) liegen, wobei der radiale Abstand der Kompensationselemente (80) größer als der radiale Abstand der Leiterabschnitte (104) zum Sensorelement (108) ist, insbesondere die Kompensationselemente (80) in einem sensoraktiven Teilabschnitt symmetrisch die Leiterabschnitte (104) einfassen.

8. Stromsensor (10, 20, 30, 40, 50, 60, 70, 100) nach Anspruch 6 oder 7, **dadurch gekennzeichnet, dass** der Stromleiter (38) im wesentlichen U-förmig mit zwei parallelen Schenkeln und einem Querschenkel (106) ausgebildet ist, wobei die beiden parallelen Schenkel des Stromleiters (38) die Leiterabschnitte (104) bilden, und wobei bevorzugt räumlich benachbart zum Querschenkel (106) ein weiteres Kompensationselement (80) angeordnet ist.

9. Stromsensor (10, 20, 30, 40, 50, 60, 70, 100) nach einem der vorhergehenden Ansprüche, **dadurch gekennzeichnet, dass** das Kompensationselement (80,90) und der Stromleiter (38, 56) auf einem PCB angeordnet ist, wobei bevorzugt das Sensorelement (12, 108) auf derselben oder einer gegenüberliegenden Seite des PCBs angeordnet ist, und/oder das Kompensationselement (80,90) und der Stromleiter (38, 56) in einem Gehäuse angeordnet sind.

10. Verwendung eines Stromsensors (10, 20, 30, 40, 50, 60, 70, 100) zur magnetfeldbasierten Messung eines elektrischen Stroms durch einen Stromleiter (38,56) nach einem der vorhergehenden Ansprüchen, **dadurch gekennzeichnet, dass** frequenzabhängige Verzerrungen des Magnetfeldes durch ein, durch Induktion von Wirbelströmen in das zumindest eine leitfähige Kompensationselement (80, 90) hervorgerufenes, Kompensationsmagnetfeld kompensiert werden.

## Claims

1. A current sensor (10, 20, 30, 40, 50, 60, 70, 100) for magnetic field-based current determination of an alternating current I through a current conductor (38, 56) on the basis of a magnetic field-sensitive sensor element (12, 108), wherein the sensor element (12, 108) is arranged spatially adjacent the current conductor (38, 56) for detecting a magnetic field brought about in the current conductor (38, 56) by the alternating current I, **characterised in that** at least one metal block in the form of a conductive compensation element (80, 90) with a cross-sectional area of at least 50% to 100% of the cross-sectional area of the current conductor (38, 56) is arranged in electrically isolated manner from the flow of alternating current I through the current conductor (38, 56) and in such a way spatially adjacent the sensor element (12, 108) and the current conductor (38, 56) to compensate frequency-dependent distortions of the magnetic field by means of a compensation magnetic field arising by eddy current induction, such that interfering influences of frequency-dependent current density effects of the current conductor (38, 56) on the sensor element (12, 108) are compensated by the compensation magnetic field of the compensation element (80, 90).

2. The current sensor (10, 20, 30, 40, 50, 60, 70, 100) according to Claim 1, **characterised in that** the compensation element (80, 90) has a conductivity which may be greater than or equal to the conductivity of the current conductor (38, 56), wherein the compensation element (80, 90) preferably consists of copper, aluminium or silver.

3. The current sensor (10, 20, 30, 40, 50, 60, 70, 100) according to one of the preceding claims, **characterised in that** the current conductor (38, 56) comprises two conductor portions (14a, 14b, 104), wherein the sensor element (12, 108) is arranged between the two conductor portions (14a, 14b, 104), and preferably configured as a gradient sensor and wherein at least one and preferably two compensation elements (80, 90) follow the course of the two conductor portions (14a, 14b, 104) substantially along one sensor-active sub-portion.

4. The current sensor (10, 20, 30, 40, 50, 60, 70, 100) according to Claim 3, **characterised in that** the alternating current I of the current conductor (56) flowing through the conductor portions (14, 14b) is subdivided relative to a cross-sectional plane through the conductor portions (14a, 14b) and flows in the same direction.

5. The current sensor (10, 20, 30, 40, 50, 60, 70, 100) according to Claim 4, **characterised in that** the conductor portions (14a, 14b) of the current conductor (56) are height-offset with regard to a measurement plane (20) of the magnetic field-sensitive gradient sensor (12), in particular **in that** one conductor portion (14b) is guided below and one conductor portion (14a) above the measurement plane (24), wherein, relative to the sensor element (12), at least two compensation elements (90) and the sensor element (12) are arranged in one plane, which extends at an angle, in particular a right angle, to a plane running through the conductor portions (14a, 14b) and the sensor element (12), and wherein furthermore a radial distance between the compensation elements (90) and the sensor element (12) may preferably be less than or equal to a radial distance between the conductor portions (14a, 14b) and the sensor element (12).

6. The current sensor (10, 20, 30, 40, 50, 60, 70, 100) according to Claim 3, **characterised in that** the alternating current I flowing through the conductor portions (104) of the current conductor (38) flows through the conductor portions (104) in the opposite direction relative to a cross-sectional plane.

7. The current sensor (10, 20, 30, 40, 50, 60, 70, 100) according to Claim 6, **characterised in that** the conductor portions (104) of the current conductor (38) and at least two compensation elements (80) lie in a measurement plane (24) of the sensor element (108), wherein the radial distance between the compensation elements (80) is greater than the radial distance between the conductor portions (104) and the sensor element (108), in particular the compensation elements (80) in a sensor-active sub-portion symmetrically surround the conductor portions (104).

8. The current sensor (10, 20, 30, 40, 50, 60, 70, 100) according to Claim 6 or 7, **characterised in that** the current conductor (38) is substantially U-shaped with two parallel legs and a transverse leg (106), wherein the two parallel legs of the current conductor (38) form the conductor portions (104), and wherein a further compensation element (80) is preferably arranged spatially adjacent the transverse leg (106).

9. The current sensor (10, 20, 30, 40, 50, 60, 70, 100) according to one of the preceding claims, **characterised in that** the compensation element (80, 90) and the current conductor (38, 56) are arranged on a PCB, wherein the sensor element (12, 108) is preferably arranged on the same or an opposing side of the PCB, and/or the compensation element (80, 90) and the current conductor (38, 56) are arranged in a housing.

10. A use of a current sensor (10, 20, 30, 40, 50, 60, 70, 100) for magnetic field-based measurement of an electrical current through a current conductor (38, 56) according to one of the preceding claims, **characterised in that** frequency-dependent distortions of the magnetic field are compensated by a compensation magnetic field generated by eddy current induction in the at least one conductive compensation element (80, 90).

**Revendications**

1. Capteur de courant (10, 20, 30, 40, 50, 60, 70, 100) permettant de déterminer, en se basant sur un champ magnétique, un courant alternatif I à travers un conducteur de courant (38, 56) sur la base d'un élément capteur (12, 108) sensible au champ magnétique, sachant que l'élément capteur (12, 108) est disposé en étant adjacent dans l'espace au conducteur de courant (38, 56) pour la détection d'un champ magnétique généré par le courant alternatif I dans le conducteur de courant (38, 56), **caractérisé en ce qu'**au moins un bloc métallique conçu sous la forme d'un élément de compensation conducteur (80, 90) ayant une surface de section transversale comprise entre au moins 50 % et 100 % de la surface de section transversale du conducteur de courant (38, 56) est séparé par galvanisation du flux du courant alternatif I traversant le conducteur de courant (38, 56) et disposé en étant adjacent dans l'espace à l'élément capteur (12, 108) et au conducteur de courant (38, 56) pour la compensation de distorsions du champ magnétique dépendant de la fréquence au moyen d'un champ magnétique de compensation résultant de l'induction de courant de Foucault, de telle sorte que des influences perturbantes des effets de densité de courant dépendant de la fréquence du conducteur de courant (38, 56) sur l'élément capteur (12, 108) sont compensées par le champ magnétique de compensation de l'élément de compensation (80, 90).

2. Capteur de courant (10, 20, 30, 40, 50, 60, 70, 100) selon la revendication 1, **caractérisé en ce que** l'élément de compensation (80, 90) présente une conductivité qui est supérieure ou égale à la conductivité du conducteur de courant (38, 56), sachant que l'élément de compensation (80, 90) est de préférence en cuivre, en aluminium ou en argent.

3. Capteur de courant (10, 20, 30, 40, 50, 60, 70, 100) selon l'une des revendications précédentes, **caractérisé en ce que** le conducteur de courant (38, 56) comprend deux sections de conducteur (14a, 14b, 104), sachant que l'élément capteur (12, 108) est disposé entre les deux sections de conducteur (14a, 14b, 104), et est conçu de préférence sous forme d'un capteur à gradient, et sachant qu'au moins un, de préférence deux éléments de compensation (80, 90) suivent le tracé des deux sections de conducteur (14a, 14b, 104) essentiellement le long d'une section partielle active au niveau du capteur.

4. Capteur de courant (10, 20, 30, 40, 50, 60, 70, 100) selon la revendication 3, **caractérisé en ce que**, en se référant à un plan de section transversale à travers les sections du conducteur (14a, 14b), le courant alternatif I du conducteur de courant (56) qui circule à travers les sections de conducteur (14a, 14b) se répartit et circule dans le même sens.

5. Capteur de courant (10, 20, 30, 40, 50, 60, 70, 100) selon la revendication 4, **caractérisé en ce que** les sections (14a, 14b) du conducteur de courant (56) sont décalées en hauteur par rapport à un plan de mesure (20) du capteur à gradient (12) sensible au champ magnétique, en particulier **en ce qu'**une section de conducteur (14b) est guidée en dessous du plan de mesure (24) et une section de conducteur (14a) en dessus, sachant qu'au niveau de l'élément capteur (12), au moins deux éléments de compensation (90) et l'élément capteur (12) sont disposés sur un plan qui forme un angle, en particulier un angle droit, par rapport à un plan traversant les sections de conducteur (14a, 14b) et l'élément capteur (12), et sachant en outre qu'un écart radial des éléments de compensation (90) par rapport à l'élément capteur (12) est de préférence égal ou inférieur à un écart radial des sections de conducteur (14a, 14b) par rapport à l'élément capteur (12).

6. Capteur de courant (10, 20, 30, 40, 50, 60, 70, 100) selon la revendication 3, **caractérisé en ce qu'**au niveau d'un plan de section transversale à travers les sections du conducteur (104), le courant alternatif I circulant à travers les sections (104) du conducteur de courant (38) s'écoule dans des directions opposées.

7. Capteur de courant (10, 20, 30, 40, 50, 60, 70, 100) selon la revendication 6, **caractérisé en ce que** les sections (104) du conducteur de courant (38) et au moins deux éléments de compensation (80) se trouvent sur un plan de mesure (24) de l'élément capteur (108), sachant que l'écart radial des éléments de compensation (80) est supérieur à l'écart radial des sections de conducteur (104) par rapport à l'élément capteur (108), en particulier que les éléments de compensation (80) encadrent symétriquement les sections de conducteur (104) dans une section partielle active au niveau du capteur.

8. Capteur de courant (10, 20, 30, 40, 50, 60, 70, 100) selon la revendication 6 ou 7, **caractérisé en ce que** le conducteur de courant (38) est essentiellement conçu en forme de U avec deux branches parallèles et une branche transversale (106), sachant que les deux branches parallèles du conducteur de courant (38) forment les sections de conducteur (104), et sachant que, de préférence, un autre élément de compensation (80) est disposé en étant adjacent dans l'espace à la branche transversale (106).

9. Capteur de courant (10, 20, 30, 40, 50, 60, 70, 100) selon l'une des revendications précédentes, **caractérisé en ce que** l'élément de compensation (80, 90) et le conducteur de courant (38, 56) sont disposés sur un circuit imprimé (PCB), sachant que l'élément capteur (12, 108) est disposé de préférence sur la même face ou sur une face opposée du PCB, et/ou l'élément de compensation (80, 90) et le conducteur de courant (38, 56) sont disposés dans un boîtier.

10. Utilisation d'un capteur de courant (10, 20, 30, 40, 50, 60, 70, 100) permettant de mesurer, en se basant sur un champ magnétique, un courant électrique à travers un conducteur de courant (38, 56) selon l'une des revendications précédentes, **caractérisé en ce que** des distorsions du champ magnétique dépendant de la fréquence sont compensées par un champ magnétique de compensation généré par l'induction de courants de Foucault dans l'au moins un élément de compensation conducteur (80, 90).

38

104    102    104    1000

I →              I →

↑    108    ↓

→    →

106    106

Fig. 1          Stand der Technik

1010

102    1012

1016

38

I →

1014    1014

1016

1016

106    106

104    ↑ I    I ↓    104

108

I →    I →

106    106

Fig. 2          Stand der Technik

Fig. 3    Stand der Technik

Fig. 4    Stand der Technik

Fig. 5a

A-A:

Fig. 5b

20
38
102
80
104
80
104
80
108
106
106

*I*

Fig. 5c

30
38
102
80
94
104
94
80
94
104
80
108
106
106

*I*

Fig. 5d

A-A DC:

Fig. 6a

A-A AC:

Fig. 6b

A-A AC comp.:

Fig. 6c

Fig. 7

Fig. 8

Fig. 9

Fig. 10

Fig. 11

EP 4 010 714 B1

Fig. 12

Fig. 13

Fig. 14

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 4300605 A1
- WO 2014001473 A1
- WO 2019072421 A1
- DE 10110254 A1
- DE 102017114377 A1